# EUROPEAN PATENT SPECIFICATION

(11) **EP 4 015 486 B1**
(45) Date of publication and mention of the grant of the patent: **17.01.2024**
(21) Application number: 20854862.8
(22) Date of filing: 05.08.2020
(51) Int. Cl.: C04B 35/587, C04B 37/02, C04B 41/91, H01L 23/13, H01L 23/15, H05K 1/03, H05K 3/38, C04B 35/111, C04B 35/565, C04B 35/581, C04B 35/583, C04B 35/645, C04B 41/53

(54) **CERAMIC SUBSTRATE, CIRCUIT BOARD AND METHOD FOR PRODUCING SAME, AND POWER MODULE**
KERAMIKSUBSTRAT, LEITERPLATTE, VERFAHREN ZU DEREN HERSTELLUNG UND LEISTUNGSMODUL
SUBSTRAT EN CÉRAMIQUE, CARTE DE CIRCUIT IMPRIMÉ ET SON PROCÉDÉ DE PRODUCTION, ET MODULE D'ALIMENTATION

(30) Priority: 16.08.2019 JP 2019149319
(43) Date of publication of application: 22.06.2022
(73) Proprietor: Denka Company Limited, Tokyo 103-8338 (JP)
(72) Inventor: YAMAGATA Toshitaka, Tokyo 103-8338 (JP); MORI Kazuhisa, Tokyo 103-8338 (JP); KOMIYA Katsuhiro, Tokyo 103-8338 (JP)
(74) Representative: Gulde & Partner
(86) International application number: PCT/JP2020/030060
(87) International publication number: WO 2021/033553

(56) References cited:
- EP-A1- 3 712 933
- WO-A1-2018/037842
- JP-A- 2008 172 172
- JP-A- 2009 239 041
- JP-A- 2011 187 511
- JP-A- 2019 052 072
- KR-A- 20180 131 072
- US-A1- 2002 164 475

## Description

### Technical Field

The present disclosure relates to a ceramic substrate, a circuit board and a method for producing the same, and a power module.

### Background Art

Power modules controlling large currents are used in automotive, electric railway, and industrial equipment fields, power generation-related fields, and so on. Ceramic substrates are used as insulating substrates mounted on the power modules. In such applications, the ceramic substrates are required to have satisfactory heat radiation characteristics in addition to insulating properties. For example, a ceramic substrate made of a material containing aluminum nitride, alumina, silicon nitride, or silicon carbide as a main component has been proposed in Patent Literature 1.

In addition, with the technique that has been proposed in Patent Literature 2, a ceramic substrate used for a semiconductor module is given a surface roughness Ra of 0.1 to 5 µm, a resin layer penetrates the microscopic unevenness of the surface of the ceramic substrate, and the adhesiveness of the resin layer is improved as a result. Patent Literature 3 discloses a semiconductor module with an insulated substrate, a circuit pattern formed on the insulated substrate, a semiconductor element joined on the circuit pattern and a sealing rein for sealing the insulated substrate, the circuit pattern, and the semiconductor element. A certain part of the surface of the insulated substrate has an average roughness derived in a 300-µm-wide range of 0.15 µm or greater, and an average roughness derived in a 3-µm-wide range of 0.02 µm or greater. Patent Literature 4 is directed to a method of manufacturing a heat dissipation circuit board and Patent Literature 5 to a silicon nitride sintered body and to a silicon nitride substrate which has a surface condition or texture excellent in bonding strength and thermal cycle resistance and which is suitable for producing circuit boards.

### Citation List

### Patent Literature

Patent Literature 1: JP 2017-212316 A
Patent Literature 2: JP 2016-181715 A
Patent Literature 3: EP 3 712 933 A1
Patent Literature 4: KR 2018 0131072 A
Patent Literature 5: US 2002/164475 A1

### Summary of Invention

### Technical Problem

The power modules are important products controlling various devices and thus are required to function with stability. Ceramic substrates used as components in such power modules and various other applications are required to be highly reliable. Meanwhile, various products such as power modules are used in various fields and, as such, further improvement in reliability is required regarding each component as well.

In this regard, in the present disclosure, a ceramic substrate having excellent reliability as a component is provided. In addition, a circuit board having excellent reliability as a component and a method for producing the same are provided. In addition, in the present disclosure, a power module excellent in reliability by including such a circuit board is provided.

### Solution to Problem

A ceramic substrate according to one aspect of the present disclosure has a first region and a second region having different surface roughness in at least one main surface wherein the first region has a surface roughness Ra₁ smaller than the surface roughness of the second region, at least a part of the first region is configured so that a conductor portion can be joined to at least a part of the first region, wherein the ceramic substrate contains silicon nitride and a metal oxide having Y and Mg as constituent elements, and a mass ratio of Y to Mg in the metal oxide is 0.3 to 3 when the constituent elements are converted into Y₂O₃ and MgO, respectively. In such a ceramic substrate, adhesiveness or joinability in relation to members can be adjusted depending on the types of the members coming into contact with the main surface. Such a ceramic substrate has excellent reliability as a component.

A ratio of a surface roughness Ra₂ in the second region to a surface roughness Ra₁ in the first region may be 1.5 or more. By having the main surface with a considerable difference in surface roughness as described above, adhesiveness or joinability in relation to members can be sufficiently adjusted depending on the types of the members coming into contact with the main surface. Such a ceramic substrate has more excellent reliability as a component.

The second region has a surface roughness Ra₂ larger than the surface roughness of the first region, and at least a part of the second region may adhere to a resin. The second region has the surface roughness Ra₂ larger than the surface roughness Ra₁ of the first region, and thus the adhesiveness between the second region and the resin can be improved by an anchor effect.

The first region has a surface roughness Ra₁ smaller than the surface roughness of the second region, and a conductor portion may be joined to at least a part of the first region. The first region has the surface roughness Ra₁ smaller than the surface roughness Ra₂ and thus can be sufficiently firmly joined to the conductor portion using, for example, a brazing material.

According to the present invention the ceramic substrate contains a ceramic component and a metal oxide different from the ceramic component and having Y and Mg as constituent elements and the mass ratio of Y to Mg in the metal oxide is 0.3 to 3 when the constituent elements are converted into Y₂O₃ and MgO, respectively. With such a ceramic substrate, the surface roughness of the main surface can be adjusted with a high degree of freedom by etching. Accordingly, in a composite substrate of the ceramic substrate and a metal substrate, for example, the surface roughness of the main surface can also be adjusted when the metal substrate is removed by etching and a conductor portion is formed.

An area ratio of the first region in the main surface of the ceramic substrate may be 30 to 90% and an area ratio of the second region in the main surface may be 10 to 70%. With such a ceramic substrate, reliability can be improved in various applications.

The ceramic substrate may contain silicon nitride and a metal oxide having Y and Mg as constituent elements. Ratios of the metal oxide to the silicon nitride in the first region and the second region may be different from each other. In such a ceramic substrate, the surface roughness in the first region and the second region can be sufficiently different.

A circuit board according to one aspect of the present disclosure includes: the ceramic substrate according to any of the above; and a conductor portion joined to at least a part of the first region. The first region has the surface roughness Ra₁ smaller than the surface roughness Ra₂ of the second region and thus can be sufficiently firmly joined to the conductor portion using, for example, a brazing material. Accordingly, the circuit board has excellent reliability as a component.

In the circuit board, at least a part of the second region and a resin may be bonded to each other. The second region has the surface roughness Ra₂ larger than the surface roughness Ra₁ of the first region, and thus the adhesiveness between the second region and the resin can be improved by an anchor effect.

A power module according to one aspect of the present disclosure includes: the circuit board according to any of the above; and a resin sealing the circuit board, in which at least a part of the second region and the resin are bonded to each other. Such a power module is excellent in reliability as the adhesiveness between the resin and the ceramic substrate is excellent.

The power module may include: the conductor portion of the circuit board; and a semiconductor element electrically connected to the conductor portion, in which the semiconductor element may be sealed with the resin together with the circuit board. Such a power module is capable of maintaining the adhesiveness between the resin and the ceramic substrate even when, for example, the semiconductor element generates heat. Accordingly, high reliability can be maintained.

A circuit board production method according to one aspect of the present disclosure includes: a step of obtaining a composite substrate by joining a metal substrate to a main surface of a ceramic substrate having a surface roughness Ra₁; the ceramic substrate (100) containing silicon nitride and a metal oxide having Y and Mg as constituent elements, and a mass ratio of Y to Mg in the metal oxide being 0.3 to 3 when the constituent elements are converted into Y₂O₃ and MgO, respectively and a step of forming a conductor portion by removing a part of the metal substrate in the composite substrate by etching, in which a region having a surface roughness Ra₂ larger than the surface roughness Ra₁ is formed in the main surface of the ceramic substrate by the etching. According to this production method, the region having the surface roughness Ra₂ can be formed in the main surface of the ceramic substrate while the metal substrate is etched. Accordingly, a circuit board having excellent reliability as a component can be produced without increasing the number of processes.

### Advantageous Effects of Invention

According to the present disclosure, a ceramic substrate having excellent reliability as a component can be provided. In addition, a circuit board having excellent reliability as a component and a method for producing the same can be provided. In addition, a power module excellent in reliability by including such a circuit board can be provided.

### Brief Description of Drawings

FIG. 1 is a perspective view of a ceramic substrate according to an embodiment.
FIG. 2 is a cross-sectional view of a circuit board according to an embodiment.
FIG. 3 is a cross-sectional view of a power module according to an embodiment.
FIG. 4 is an optical micrograph of a main surface of a ceramic substrate of Example 1.
FIG. 5 is a scanning electron micrograph of a cross section of the ceramic substrate of Example 1.
FIG. 6 is an optical micrograph of a main surface of a ceramic substrate of Example 2.
FIG. 7 is a scanning electron micrograph of a cross section of the ceramic substrate of Example 2.

### Description of Embodiments

Hereinafter, an embodiment of the present disclosure will be described with reference to the drawings as the case may be. However, the following embodiments are examples for describing the present disclosure and the present invention is not intended to be limited to the following content. In the description, the same reference numerals are used for the same elements or elements identical in terms of function with redundant description omitted as the case may be. The dimensional ratio of each element is not limited to the illustrated ratio.

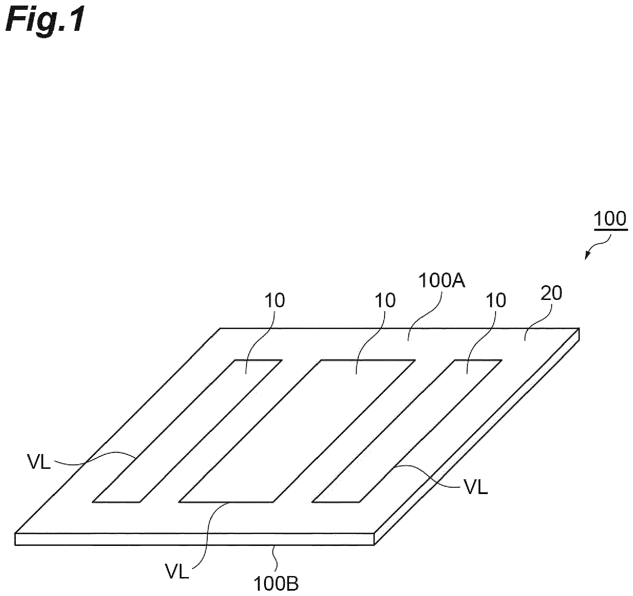

FIG. 1 is a perspective view of a ceramic substrate according to an embodiment. A ceramic substrate 100 of FIG. 1 has a flat plate shape. In the ceramic substrate 100, one main surface 100A is partitioned into first regions 10 and a second region 20 having different surface roughness. The first regions 10 are surrounded by the second region 20. Partition lines VL partitioning the main surface 100A into the first regions 10 and the second region 20 are boundary lines indicating the boundaries between the first regions 10 and the second region 20 and may be virtual lines. One of the first regions 10 and the second region 20 each have an area of 100 mm² or more.

A surface roughness Ra₂ in the second region 20 is larger than a surface roughness Ra₁ in the first region 10. The ratio of the surface roughness Ra₂ in the second region 20 to the surface roughness Ra₁ in the first region 10 may be 1.5 or more, 1.8 or more, or 2.0 or more. By increasing the ratio, adhesiveness or joinability in relation to members can be sufficiently adjusted depending on the types of the members coming into contact with the main surface 100A. The ceramic substrate 100 as described above has more excellent reliability as a component. From a similar viewpoint, the difference between the surface roughness Ra₂ in the second region 20 and the surface roughness Ra₁ in the first region 10 may be 0.1 µm or more and may be 0.2 µm or more.

The ratio of the surface roughness Ra₂ in the second region 20 to the surface roughness Ra₁ in the first region 10 may be 5.0 or less, 4.0 or less, or 3.0 or less. By reducing the ratio, the surface roughness Ra₂ becoming excessive can be suppressed and the strength of the ceramic substrate 100 can be kept sufficiently high. From a similar viewpoint, the difference between the surface roughness Ra₂ in the second region 20 and the surface roughness Ra₁ in the first region 10 may be 1.5 µm or less and may be 0.5 µm or less.

A conductor portion is joined to at least a part of the first region 10 via, for example, a brazing material. The first region 10 has the surface roughness Ra₁ smaller than the surface roughness Ra₂, and thus the first region 10 can be sufficiently firmly joined to the conductor portion by the brazing material. At least a part of the second region 20 adheres to, for example, a resin. The second region 20 has the surface roughness Ra₂ larger than the surface roughness Ra₁, and thus the adhesiveness between the second region 20 and the resin can be improved by an anchor effect.

From the viewpoint of improving joinability in relation to a conductor while enabling easy production, the surface roughness Ra₁ in the first region 10 may be, for example, 0.05 to 1.0 µm, 0.1 to 0.8 µm, or 0.15 to 0.4 µm. From the viewpoint of increasing adhesiveness in relation to a resin while maintaining the strength of the ceramic substrate 100, the surface roughness Ra₂ in the second region 20 may be, for example, 0.2 to 3.0 µm, 0.3 to 2.0 µm, or 0.45 to 1.0 µm. The surface roughness Ra₁ and the surface roughness Ra₂ in the present disclosure are center line average roughness and values measured in accordance with JIS B 0601-2001.

Although the surface roughness at respective positions in the first region 10 may vary slightly, the variation is 0.1 µm or less. In other words, the positions can be regarded as the first region 10 insofar as the difference between the maximum value and the minimum value is 0.1 µm or less. Likewise, although the surface roughness at respective positions in the second region 20 may vary slightly, the variation is 0.1 µm or less. In other words, the positions can be regarded as the second region 20 insofar as the difference between the maximum value and the minimum value is 0.1 µm or less.

In a case where the plurality of first regions 10 are provided as in the present embodiment, the surface roughness Ra₁ of each first region 10 is within the range of the average value of the surface roughnesses Ra₁ of the three first regions 10 minus 0.05 µm to the average value of the surface roughnesses Ra₁ of the three first regions 10 plus 0.05 µm. Likewise, in a case where a plurality of the second regions 20 are provided, the surface roughness Ra₂ of each second region 20 is within the range of the average value of the surface roughnesses Ra₂ of the plurality of second regions 20 minus 0.05 µm to the average value of the surface roughnesses Ra₂ of the plurality of second regions 20 plus 0.05 µm.

The main surface 100A of the ceramic substrate 100 is configured by the first region 10 and the second region 20. The area ratio of the first region 10 may be 30 to 90% and may be 40 to 80%. The area ratio of the second region 20 in the main surface 100A may be 10 to 70% and may be 20 to 60%. In the present embodiment, the first region 10 and the second region 20 are adjacent to each other in the main surface 100A. In a modification example, the main surface 100A may have one first region 10 and one second region 20. In another modification example, the first region 10 and the second region 20 may be provided so as to be arranged alternately. In addition, the main surface 100A of the ceramic substrate 100 may have another region different in surface roughness from the first region 10 and the second region 20.

The type of the ceramic component that is the main component of the ceramic substrate 100 is not particularly limited, and examples thereof include carbides, oxides, and nitrides. Specific examples thereof include silicon carbide, alumina, silicon nitride, aluminum nitride, and boron nitride. The ceramic substrate 100 contains a metal oxide different from the ceramic component in addition to the ceramic.

The metal oxide includes a metal oxide having Y and Mg as constituent elements. The mass ratio of Y to Mg in the metal oxide is 0.3 to 3 or 0.5 to 2 when those are converted into Y₂O₃ and MgO, respectively. With such a ceramic substrate, the surface roughness of the main surface 100A can be adjusted with a high degree of freedom by etching. Accordingly, in a composite substrate of the ceramic substrate 100 and a metal substrate, for example, the surface roughness of the main surface 100A can also be adjusted when the metal substrate is removed by etching and a conductor portion is formed. Accordingly, the first region 10 and the second region 20 can be smoothly formed in the main surface 100A. It should be noted that the surface roughness tends to increase as the mass ratio of Y to Mg approaches 1 when compared under the same etching conditions. On the other hand, the surface roughness tends to decrease as the difference of the mass ratio of Y to Mg from 1 increases. It is conceivable that this is because the metal oxide or a component derived from the metal oxide is removed from the main surface 100A of the ceramic substrate 100 by etching.

The metal oxide-to-silicon nitride ratios in the first region 10 and the second region 20 may be different from each other. For example, the ratio may be higher in the first region 10 than in the second region 20. In the ceramic substrate 100 as described above, the surface roughness Ra₂ in the second region 20 can be made sufficiently larger than the surface roughness Ra₁ in the first region 10.

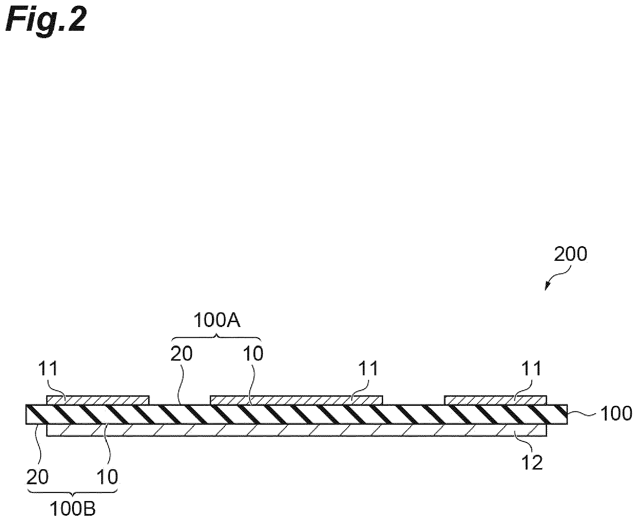

FIG. 2 is a cross sectional view of a circuit board 200 according to an embodiment. The circuit board 200 includes the ceramic substrate 100, a conductor portion 11 disposed on the main surface 100A, and a conductor portion 12 disposed on a main surface 100B. The conductor portion 11 is joined to the first region 10 of the main surface 100A. The conductor portion 11 may be joined to the main surface 100A via a brazing material (not illustrated). Meanwhile, the second region 20 of the main surface 100A is exposed without being covered with the conductor portion 11. Accordingly, when the circuit board 200 is sealed with a resin, the resin is capable of adhering to the second region 20. It should be noted that a part of the first region 10 may be exposed without being covered with the conductor portion 11.

For example, the area ratio of the region covered with the conductor portion 11 to the entire first region 10 may be 50% or more, 60% or more, 70% or more, 80% or more, or 90% or more. A part of the second region 20 may be covered with the conductor portion 11. For example, the area ratio of the region exposed without being covered with the conductor portion 11 to the entire second region 20 may be 50% or more, 60% or more, 70% or more, 80% or more, or 90% or more.

The conductor portion 12 different in shape from the conductor portion 11 is joined to the main surface 100B of the ceramic substrate 100. As in the case of the conductor portion 11, the conductor portion 12 is joined to the first region 10 in the main surface 100B. The conductor portion 12 may also be joined to the main surface 100B via a brazing material (not illustrated). Meanwhile, the second region 20 in the main surface 100B is exposed without being covered with the conductor portion 12.

In a modification example, the circuit board 200 may have a resin bonded to the second region 20. In addition, the conductor portions on the main surface 100A and the main surface 100B may have the same shape and one of the main surface 100A and the main surface 100B may lack the conductor portion.

The first region 10 of the ceramic substrate 100 of the circuit board 200 has the surface roughness Ra₁ smaller than the surface roughness Ra₂ and thus can be sufficiently firmly joined to the conductor portions 11 and 12 by a brazing material. In addition, the second region 20 has satisfactory adhesiveness in relation to a resin by an anchor effect. Accordingly, the circuit board 200 has excellent reliability as a component.

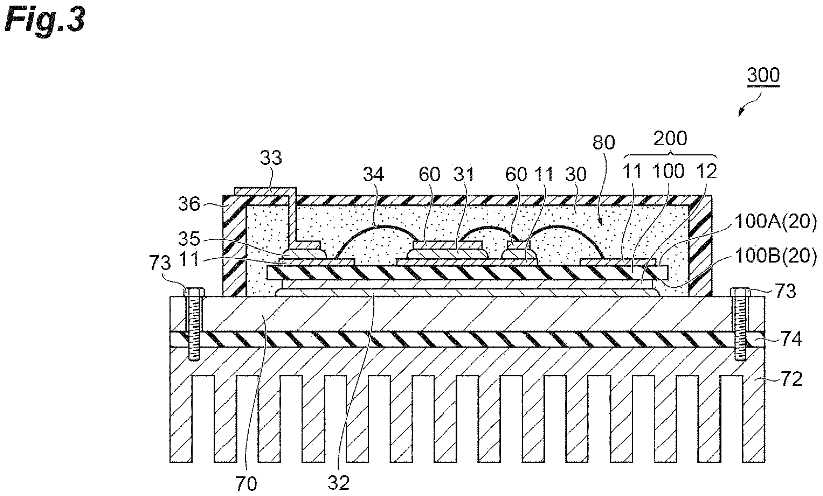

FIG. 3 is a schematic cross-sectional view of a power module 300 according to an embodiment. The power module 300 includes a base plate 70 and the circuit board 200 joined to one surface of the base plate 70 via solder 32. The conductor portion 12 of the circuit board 200 is joined to the solder 32.

A semiconductor element 60 is attached to the conductor portion 11 of the circuit board 200 via solder 31. The semiconductor element 60 is connected to a predetermined part of the conductor portion 11 by a metal wire 34 such as an aluminum wire. For electrical connection between the outside of a housing 36 and the conductor portion 11, a predetermined part of the conductor portion 11 is connected to an electrode 33, which is provided so as to penetrate the housing 36, via solder 35.

The housing 36 is disposed on one surface of the base plate 70 so as to accommodate the circuit board 200. The accommodation space formed by one surface of the base plate 70 and the housing 36 is filled with a resin 30 such as silicone gel. The resin 30 is bonded to the second region 20 in the main surfaces 100A and 100B of the ceramic substrate 100. The second region 20 has the large surface roughness Ra₁ and thus has excellent adhesiveness in relation to the resin 30. Accordingly, the power module 300 is excellent in reliability.

A cooling fin 72 forming a heat radiating member is joined to the other surface of the base plate 70 via grease 74. A screw 73 fixing the cooling fin 72 to the base plate 70 is attached to an end portion of the base plate 70. The base plate 70 and the cooling fin 72 may be made of aluminum. The base plate 70 and the cooling fin 72 satisfactorily function as heat radiating portions by having high thermal conductivity.

The conductor portion 11 and the conductor portion 12 are electrically insulated by the ceramic substrate 100. The conductor portion 11 may or may not form an electric circuit. The materials of the conductor portion 11 and the conductor portion 12 may be the same or different. The conductor portion 11 and the conductor portion 12 may be made of copper. However, the material is not limited to copper.

The power module 300 includes the conductor portions 11 and 12 of the circuit board 200 and the semiconductor element 60 electrically connected to the conductor portion 11. The semiconductor element 60 is sealed with the resin 30 together with the circuit board 200. The power module 300 as described above is capable of maintaining the adhesiveness between the resin 30 and the ceramic substrate 100 even when the semiconductor element 60 generates heat.

The resin that adheres to the second region 20 of the ceramic substrate 100 is not limited to a sealing resin. For example, in a case where the ceramic substrate is used as a ceramic heat sink material for a pressure welding structure, the resin that adheres to the second region 20 may be a thermosetting resin or a photocurable resin.

Next, an example of how to produce the ceramic substrate will be described. First, ceramic powder made of a ceramic component and an oxide-based sintering aid functioning as a sintering aid are prepared. Examples of the oxide-based sintering aid include those containing Y₂O₃, MgO, SiO₂, Al₂O₃, and so on. The content of the oxide-based sintering aid in the raw material powder may be, for example, 4.0 to 8.0% by mass or 4.0 to 5.0% by mass from the viewpoint of obtaining a ceramic substrate (sintered body) capable of achieving both high thermal conductivity and excellent insulation at a high level.

The raw material powder described above is pressurized with a molding pressure of, for example, 3.0 to 10.0 MPa. A molded body is obtained as a result. The molded body may be produced by uniaxial pressurization or CIP. In addition, it may be fired while being molded by a hot press. The molded body may be fired in an atmosphere of an inert gas such as nitrogen gas and argon gas. The pressure during the firing may be 0.7 to 0.9 MPa. In a case where the ceramic component is silicon nitride, the firing temperature may be, for example, 1600 to 2100°C or 1800 to 2000°C. The firing time at the firing temperature may be 6 to 20 hours or 8 to 16 hours.

The sintered body obtained in this manner is processed as needed, and the ceramic substrate is obtained as a result. At this time, both main surfaces have the surface roughness Ra₁. A part of the main surface of the ceramic substrate obtained in this manner is masked with tape or the like. Then, physical polishing by sandblasting or the like or chemical treatment by etching or the like is performed. As a result, a part of the main surface of the ceramic substrate becomes the second region having the surface roughness Ra₂ and the rest becomes the first region having the surface roughness Ra₁. A conductor portion may be formed by a conductor tape or the like being attached to the first region in the main surface of the ceramic substrate obtained in this manner. The surface roughness Ra₁ of the first region is smaller than the surface roughness Ra₂, and thus the conductor tape and the first region of the conductor portion are bonded with a high adhesive force.

Methods for forming the second region are not limited to the method described above. For example, the formation may be performed by honing or by roughening the main surface with laser light or the like. In addition, the second region may be formed by etching. The etching may be repeated twice or more.

An example of how to produce the circuit board will be described. A ceramic substrate having the surface roughness Ra₁ is prepared. A metal substrate is superposed on the main surface of the ceramic substrate via a brazing material, and a composite substrate is obtained by heating in a heating furnace. The brazing material is applied to the main surface of the ceramic substrate by a method such as a roll coater method, a screen printing method, and a transfer method. The brazing material may contain, for example, a metal and a metal compound component such as Ag, Cu, Sn, and Ti, an organic solvent, a binder, and so on. The viscosity of the brazing material may be, for example, 5 to 20 Pa·s. The content of the organic solvent in the brazing material may be, for example, 5 to 25% by mass, and the content of the binder may be, for example, 2 to 15% by mass.

The heating temperature in the heating furnace may be, for example, 700 to 900°C. The atmosphere in the furnace may be an inert gas such as nitrogen, and the process may be performed under reduced pressure below atmospheric pressure or under vacuum. The heating furnace may be a continuous furnace where a plurality of joined bodies are continuously produced or a furnace where one or more joined bodies are batch-produced. The heating may be performed while pressing the joined body of the ceramic substrate and the metal substrate in the stacking direction.

Subsequently, a part of the metal substrate in the composite substrate is removed by etching and a conductor portion is formed as a result. After a part of the metal substrate is removed, a part of the main surface of the ceramic substrate exposed by removing the part is also etched. As a result, a part of the main surface is also roughened and the first region having the surface roughness Ra₁ and the second region having the surface roughness Ra₂ larger than the surface roughness Ra₁ are formed.

As described above, according to the production method of this example, a circuit board can be obtained from a composite substrate and a ceramic substrate including a main surface having a plurality of regions having different surface roughness can be obtained. Accordingly, a ceramic substrate and a circuit board having excellent reliability as components can be produced without increasing the number of processes.

A power module can be produced using the circuit board obtained in this manner. The power module can be produced by mounting a semiconductor element on the circuit board using solder, wire bonding, or the like, accommodating the circuit board and the semiconductor element in an accommodation space of a housing, and then performing resin sealing.

Although some embodiments have been described above, the present disclosure is not limited to the embodiments described above. For example, the circuit board may include a semiconductor element electrically connected to the conductor portion. In addition, there is no need to have the first region and the second region in both main surfaces and the first region and the second region may be provided in one of the main surfaces.

### Examples

Although the content of the present disclosure will be described in more detail with reference to examples and reference examples, the present disclosure is not limited to the following specific examples.

### (Example 1)

### <Production of Silicon Nitride Sintered Body>

Silicon nitride powder and magnesium oxide powder and yttrium oxide powder as sintering aids were prepared. These were mixed at Si₃N₄ : Y₂O₃ : MgO = 94.0 : 3.0 : 3.0 (mass ratio), and raw material powder was obtained as a result. The raw material powder was uniaxially pressure-molded, and a molded body was produced as a result. The molded body was disposed in an electric furnace equipped with a carbon heater and fired for 12 hours at 1800°C under nitrogen gas atmosphere. A flat plate-shaped silicon nitride sintered body was obtained as a result.

### <Etching>

A part of the silicon nitride sintered body was masked with tape and then immersed for 60 minutes in a commercially available etching solution (aqueous solution of cupric chloride). After taking out the silicon nitride sintered body from the etching solution, the silicon nitride sintered body was re-immersed in the same etching solution for 60 minutes. The etching treatment was performed twice in this manner to obtain a ceramic substrate. The tape was removed, and the appearance of the obtained ceramic substrate was observed with an optical microscope.

### <Appearance Evaluation>

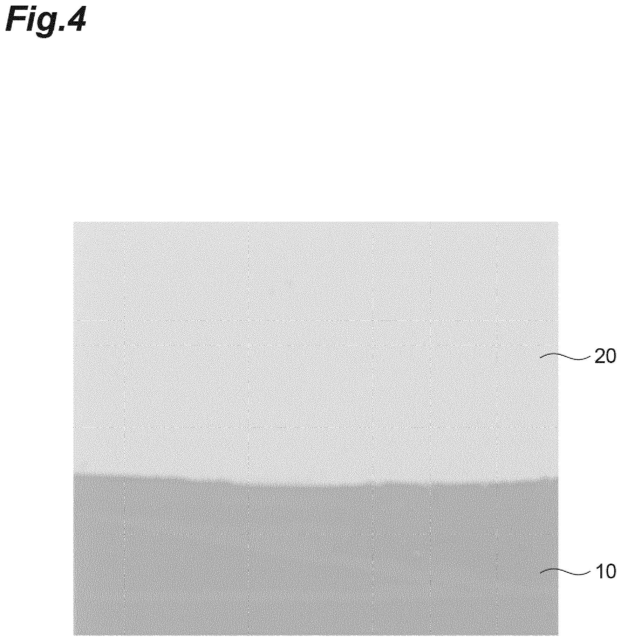

FIG. 4 is an optical micrograph of a ceramic substrate. As shown in FIG. 4, the first region 10 and the second region 20 having different shades were formed in the main surface of the ceramic substrate. The surface roughness in each region was measured using a small surface roughness measuring instrument (manufactured by Mitutoyo Corporation, product name: Surftest SJ-310). As a result, the surface roughness Ra₁ of the first region 10 was 0.25 µm and the surface roughness Ra₂ of the second region 20 was 0.50 µm.

### <Cross-sectional Evaluation>

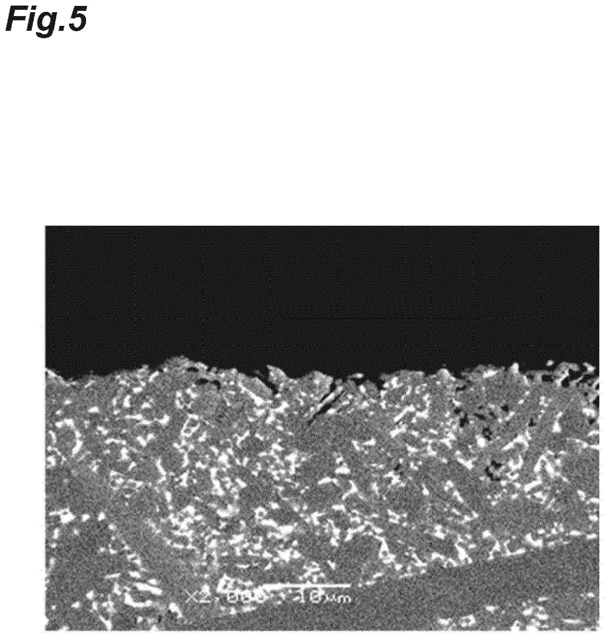

The ceramic substrate was cut along the thickness direction, and the cross section near the main surface was observed using a scanning electron microscope (SEM). FIG. 5 is an SEM photograph showing the cross section near the main surface in the second region of the ceramic substrate of Example 1. As shown in FIG. 5, it was confirmed that the surface was roughened in the second region.

### (Example 2)

### <Production of Silicon Nitride Sintered Body>

Silicon nitride powder and magnesium oxide powder, yttrium oxide powder, and silicon dioxide powder as sintering aids were prepared. These were mixed at Si₃N₄ : Y₂O₃: MgO : SiO₂ = 91.35 : 6.0 : 1.58 : 1.07 (mass ratio), and raw material powder was obtained as a result. A flat plate-shaped silicon nitride sintered body was obtained through the same procedure as in Example 1 except that the raw material powder was used. Then, etching was performed through the same procedure as in Example 1 to obtain a ceramic substrate. The tape was removed, and the appearance of the obtained ceramic substrate was observed with an optical microscope.

### <Appearance Evaluation>

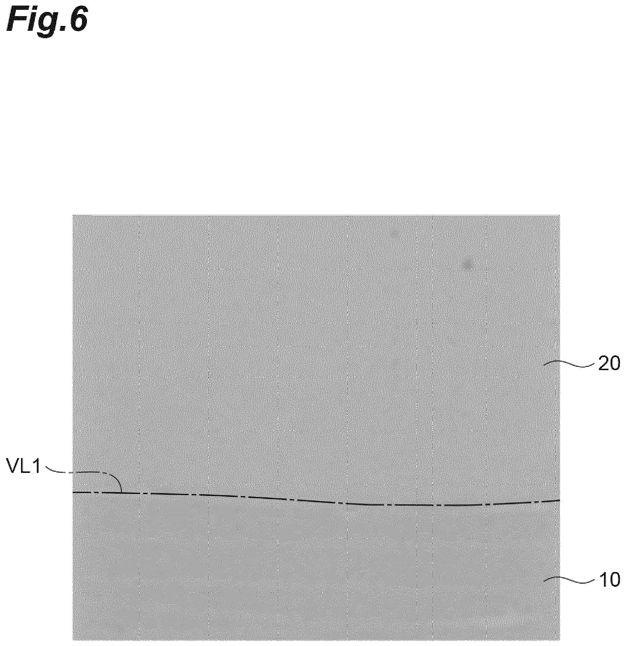

FIG. 6 is an optical micrograph of a ceramic substrate. As shown in FIG. 6, the first region 10 and the second region 20 having different shades were formed in the main surface of the ceramic substrate. However, the difference in shade was smaller than in Example 1. In FIG. 6, a virtual line VL1 is drawn at the boundary between the first region 10 and the second region 20. The surface roughness Ra₁ of the first region 10 was 0.30 µm, and the surface roughness Ra₂ of the second region 20 was 0.31 µm.

### <Cross-sectional Evaluation>

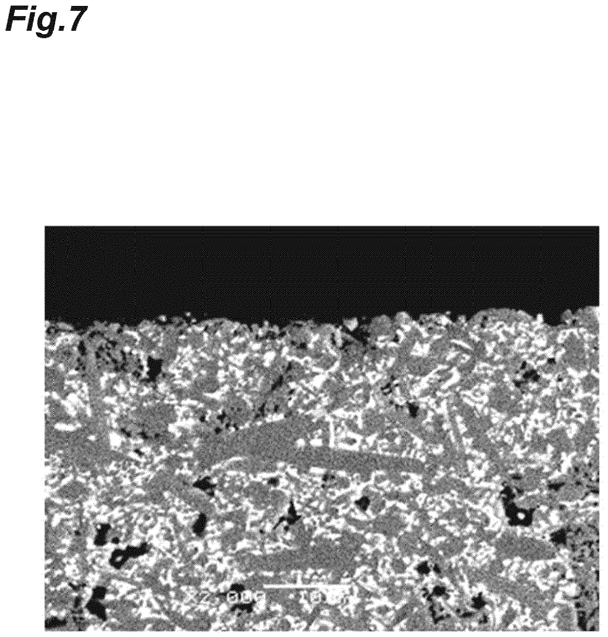

As in the case of Example 1, the cross section near the main surface was observed using a scanning electron microscope (SEM). FIG. 7 is an SEM photograph showing the cross section near the main surface in the second region of the ceramic substrate of Example 2. As shown in FIG. 7, it was confirmed that the surface was roughened in the second region. However, the surface was not as rough as shown in FIG. 5.

The flexural strengths of the ceramic substrates of Examples 1 and 2 were measured. The flexural strengths are three-point-bending flexural strengths and were measured using a commercially available flexural strength meter (manufactured by Shimadzu Corporation, device name: AG-2000) in accordance with JIS R 1601:2008. As a result, the flexural strength of the ceramic substrate of Example 1 was 802 MPa. In addition, the flexural strength of the ceramic substrate of Example 2 was 769 MPa.

### (Reference Example 1)

Prepared as a sintering aid was metal oxide powder having a mass ratio of Y to Mg of 0.1 with those converted into Y₂O₃ and MgO, respectively. The powder was mixed with silicon nitride powder to obtain raw material powder. A flat plate-shaped silicon nitride sintered body was obtained through the same procedure as in Example 1 except that the raw material powder was used. Although etching treatment was performed as in the case of Example 1, the roughening of the main surface did not proceed sufficiently and the surface roughness of the main surface could not be adjusted. However, a part of the main surface can be roughened and the first region and the second region similar to those of Examples 1 and 2 can be formed by a non-etching method (such as sandblasting).

### (Reference Example 2)

Prepared as a sintering aid was metal oxide powder having a mass ratio of Y to Mg of 5.0 with those converted into Y₂O₃ and MgO, respectively. The powder was mixed with silicon nitride powder to obtain raw material powder. A flat plate-shaped silicon nitride sintered body was obtained through the same procedure as in Example 1 except that the raw material powder was used. Although etching treatment was performed as in the case of Example 1, the roughening of the main surface did not proceed sufficiently and the surface roughness of the main surface could not be adjusted. However, as in Reference Example 1, a part of the main surface can be roughened and the first region and the second region similar to those of Examples 1 and 2 can be formed by a non-etching method (such as sandblasting).

### Industrial Applicability

According to the present disclosure, a ceramic substrate having excellent reliability as a component can be provided. In addition, a circuit board having excellent reliability as a component and a method for producing the same can be provided. In addition, a power module excellent in reliability by including such a circuit board can be provided.

### Reference Signs List

10: first region, 11, 12: conductor portion, 20: second region, 30: resin, 31, 32, 35: solder, 33: electrode, 34: metal wire, 36: housing, 60: semiconductor element, 70: base plate, 72: cooling fin, 73: screw, 74: grease, 100: ceramic substrate, 100A, 100B: main surface, 200: circuit board, 300: power module.

## Claims

1. A ceramic substrate (100) having a first region (10) and a second region (20) having different surface roughness in at least one main surface (100A, 100B),
wherein
the first region (10) has a surface roughness Ra₁ smaller than the surface roughness Ra₂ of the second region (20),
at least a part of the first region (10) is configured so that a conductor portion (11, 12) can be joined to at least a part of the first region (10),
wherein the ceramic substrate (100) contains silicon nitride and a metal oxide having Y and Mg as constituent elements, and
a mass ratio of Y to Mg in the metal oxide is 0.3 to 3 when the constituent elements are converted into Y₂O₃ and MgO, respectively.

2. The ceramic substrate (100) according to claim 1, wherein a ratio of the surface roughness Ra₂ in the second region (20) to a surface roughness Ra₁ in the first region (10) is 1.5 or more, wherein the surface roughness is measured in accordance with JIS B 0601-2001.

3. The ceramic substrate (100) according to claim 1 or 2, wherein at least a part of the second region (20) adheres to a resin.

4. The ceramic substrate (100) according to any one of claims 1 to 3, wherein an area ratio of the first region (10) in the main surface (100A, 100B) is 30 to 90% and an area ratio of the second region (20) in the main surface (100A, 100B) is 10 to 70%.

5. The ceramic substrate (100) according to any one of claims 1 to 4, containing a ceramic component and a metal oxide different from the ceramic component and having Y and Mg as constituent elements,
wherein ratios of the metal oxide to the ceramic component in the first region (10) and the second region (20) are different from each other.

6. A circuit board (200) comprising:
the ceramic substrate (100) according to any one of claims 1 to 5; and
a conductor portion (11, 12) joined to at least a part of the first region (10).

7. The circuit board (200) according to claim 6, wherein
at least a part of the second region (20) and a resin are bonded to each other.

8. A power module (300) comprising:
the circuit board (200) according to claim 6 or 7; and
a resin (30) sealing the circuit board (200),
wherein at least a part of the second region (20) and the resin (30) are bonded to each other.

9. The power module (300) according to claim 8, comprising:
the conductor portion (11, 12) of the circuit board (200); and
a semiconductor element (60) electrically connected to the conductor portion (11, 12),
wherein the semiconductor element (60) is sealed with the resin (30) together with the circuit board (200).

10. A circuit board production method comprising:
a step of obtaining a composite substrate by joining a metal substrate to a main surface (100A, 100B) of a ceramic substrate (100) having a surface roughness Ra₁, the ceramic substrate (100) containing silicon nitride and a metal oxide having Y and Mg as constituent elements, and a mass ratio of Y to Mg in the metal oxide being 0.3 to 3 when the constituent elements are converted into Y₂O₃ and MgO, respectively; and
a step of forming a conductor portion by removing a part of the metal substrate in the composite substrate by etching,
wherein a region (20) having a surface roughness Ra₂ larger than the surface roughness Ra₁ is formed in the main surface (100A, 100B) of the ceramic substrate (100) by the etching.

## Patentansprüche

1. Keramiksubstrat (100), das einen ersten Bereich (10) und einen zweiten Bereich (20) mit unterschiedlicher Oberflächenrauhigkeit in mindestens einer Hauptfläche (100A, 100B) umfasst, wobei
der erste Bereich (10) eine Oberflächenrauhigkeit Ra₁ aufweist, die kleiner ist als die Oberflächenrauhigkeit Ra₂ des zweiten Bereichs (20),
zumindest ein Teil des ersten Bereichs (10) so konfiguriert ist, dass ein Leiterabschnitt (11, 12) mit zumindest einem Teil des ersten Bereichs (10) verbunden werden kann,
wobei das Keramiksubstrat (100) Siliziumnitrid und ein Metalloxid mit Y und Mg als konstituierende Elemente enthält, und
das Massenverhältnis von Y zu Mg im Metalloxid 0,3 zu 3 beträgt, wenn die konstituierenden Elemente in Y₂O₃ bzw. MgO umgewandelt werden.

2. Keramiksubstrat (100) nach Anspruch 1, wobei das Verhältnis der Oberflächenrauhigkeit Ra₂ im zweiten Bereich (20) zu einer Oberflächenrauhigkeit Ra₁ im ersten Bereich (10) 1,5 oder mehr beträgt, wobei die Oberflächenrauhigkeit gemäß JIS B 0601-2001 gemessen wird.

3. Keramiksubstrat (100) nach Anspruch 1 oder 2, wobei mindestens ein Teil des zweiten Bereichs (20) an einem Harz haftet.

4. Keramiksubstrat (100) nach einem der Ansprüche 1 bis 3, wobei ein Flächenverhältnis des ersten Bereichs (10) in der Hauptoberfläche (100A, 100B) 30 bis 90% und ein Flächenverhältnis des zweiten Bereichs (20) in der Hauptoberfläche (100A, 100B) 10 bis 70% beträgt.

5. Keramiksubstrat (100) nach einem der Ansprüche 1 bis 4, das eine Keramikkomponente und ein Metalloxid enthält, das sich von der Keramikkomponente unterscheidet und Y und Mg als konstituierende Elemente aufweist,
wobei die Verhältnisse des Metalloxids zu der Keramikkomponente in dem ersten Bereich (10) und dem zweiten Bereich (20) unterschiedlich sind.

6. Leiterplatte (200), umfassend:
das Keramiksubstrat (100) nach einem der Ansprüche 1 bis 5; und
einen Leiterabschnitt (11, 12), der mit mindestens einem Teil des ersten Bereichs (10) verbunden ist.

7. Leiterplatte (200) nach Anspruch 6, wobei
zumindest ein Teil des zweiten Bereichs (20) und ein Harz miteinander verbunden sind.

8. Leistungsmodul (300), das Folgendes umfasst:
die Leiterplatte (200) nach Anspruch 6 oder 7; und
ein Harz (30), das die Leiterplatte (200) versiegelt,
wobei zumindest ein Teil des zweiten Bereichs (20) und das Harz (30) miteinander verbunden sind.

9. Leistungsmodul (300) nach Anspruch 8, umfassend:
den Leiterabschnitt (11, 12) der Leiterplatte (200); und
ein Halbleiterelement (60), das elektrisch mit dem Leiterabschnitt (11, 12) verbunden ist,
wobei das Halbleiterelement (60) zusammen mit der Leiterplatte (200) mit dem Harz (30) versiegelt wird.

10. Verfahren zur Herstellung einer Leiterplatte, das Folgendes umfasst:
einen Schritt des Erhaltens eines Verbundsubstrats durch Verbinden eines Metallsubstrats mit einer Hauptoberfläche (100A, 100B) eines Keramiksubstrats (100) mit einer Oberflächenrauhigkeit Ra₁, wobei das Keramiksubstrat (100) Siliziumnitrid und ein Metalloxid mit Y und Mg als konstituierenden Elementen enthält und eine Massenverhältnis von Y zu Mg im Metalloxid 0,3 bis 3 beträgt, wenn die konstituierenden Elemente in Y₂O₃ bzw. MgO umgewandelt werden; und
einen Schritt der Ausbildung eines Leiterabschnitts durch Entfernen eines Teils des Metallsubstrats in dem Verbundsubstrat durch Ätzen,
wobei in der Hauptoberfläche (100A, 100B) des Keramiksubstrats (100) durch das Ätzen ein Bereich (20) ausgebildet wird, der eine Oberflächenrauhigkeit Ra₂ aufweist, die größer ist als die Oberflächenrauhigkeit Ra₁.

## Revendications

1. Substrat céramique (100) comportant une première région (10) et une deuxième région (20) présentant une rugosité de surface différente dans au moins une surface principale (100A, 100B),
dans lequel
la première région (10) présente une rugosité de surface Ra₁ inférieure à la rugosité de surface Ra₂ de la deuxième région (20),
au moins une partie de la première région (10) est configurée de manière à ce qu'une partie conductrice (11, 12) puisse être jointe à au moins une partie de la première région (10),
dans lequel le substrat céramique (100) contient du nitrure de silicium et un oxyde métallique ayant Y et Mg comme éléments constitutifs, et
un rapport de masse entre Y et Mg dans l'oxyde métallique est de 0,3 à 3 lorsque les éléments constitutifs sont convertis en Y₂O₃ et MgO, respectivement

2. Substrat céramique (100) selon la revendication 1, dans lequel un rapport de la rugosité de surface Ra₂ dans la deuxième région (20) à une rugosité de surface Ra₁ dans la première région (10) est de 1,5 ou plus, la rugosité de surface étant mesurée conformément à la norme JIS B 0601-2001.

3. Substrat céramique (100) selon la revendication 1 ou 2, dans lequel au moins une partie de la deuxième région (20) adhère à une résine.

4. Substrat céramique (100) selon l'une quelconque des revendications 1 à 3, dans lequel un rapport de surface de la première région (10) dans la surface principale (100A, 100B) est de 30 à 90% et un rapport de surface de la deuxième région (20) dans la surface principale (100A, 100B) est de 10 à 70%.

5. Substrat céramique (100) selon l'une quelconque des revendications 1 à 4, contenant un composant céramique et un oxyde métallique différent du composant céramique et ayant Y et Mg comme éléments constitutifs,
dans lequel des rapports entre l'oxyde métallique et le composant céramique dans la première région (10) et la deuxième région (20) sont différents l'un de l'autre.

6. Carte de circuit imprimé (200), comprenant :
le substrat céramique (100) selon l'une quelconque des revendications 1 à 5 ; et
une partie conductrice (11, 12) jointe à au moins une partie de la première région (10).

7. Carte de circuit imprimé (200) selon la revendication 6, dans laquelle
au moins une partie de la deuxième région (20) et une résine sont liées l'une à l'autre.

8. Module d'alimentation (300), comprenant :
la carte de circuit imprimé (200) selon la revendication 6 ou 7 ; et
une résine (30) scellant la carte de circuit imprimé (200),
dans lequel au moins une partie de la deuxième région (20) et de la résine (30) sont liées l'une à l'autre.

9. Module d'alimentation (300) selon la revendication 8, comprenant :
la partie conductrice (11, 12) de la carte de circuit imprimé (200) ; et
un élément semi-conducteur (60) connecté électriquement à la partie conductrice (11, 12),
dans lequel l'élément semi-conducteur (60) est scellé par la résine (30) avec la carte de circuit imprimé (200).

10. Procédé de production de carte de circuit imprimé, comprenant :
une étape consistant à obtenir un substrat composite en joignant un substrat métallique à une surface principale (100A, 100B) d'un substrat céramique (100) ayant une rugosité de surface Ra₁, le substrat céramique (100) contenant du nitrure de silicium et un oxyde métallique ayant Y et Mg comme éléments constitutifs, et un rapport de masse de Y à Mg dans l'oxyde métallique étant de 0,3 à 3 lorsque les éléments constitutifs sont convertis en Y₂O₃ et en MgO, respectivement ; et
une étape consistant à former une partie conductrice en enlevant une partie du substrat métallique dans le substrat composite par gravure,
dans lequel une région (20) présentant une rugosité de surface Ra₂ supérieure à la rugosité de surface Ra₁ est formée dans la surface principale (100A, 100B) du substrat céramique (100) par la gravure.
